# EUROPEAN PATENT APPLICATION

(11) **EP 2 560 200 A2**
(43) Date of publication of application: **20.02.2013**
(21) Application number: 12178786.5
(22) Date of filing: 01.08.2012
(51) Int. Cl.: H01L 23/051

(54) **Diode Structure**

(30) Priority: 18.08.2011 TW 100215395
(71) Applicant: K.S. Terminals Inc., Xianxi Township Chang hua 507 (TW)
(72) Inventor: Lu, Yuan-Feng, 507 CHANGHUA COUNTY (TW)
(74) Representative: Becker Kurig Straus

(57) **Abstract**

A diode structure includes a body (10), a first electrode (20), and a second electrode (30). The body (10) has a longitudinal length (d2) and a transverse length (d3). The first electrode (20) has an end extending into the body (10) along the longitudinal length (d2), and has another end extending outwardly and horizontally from the body (10) for a predetermined length (d1). The second electrode (30) lying on another side of the body (10) to oppose the first electrode (20), has a tail extending into the body (10), and has another tail extending outward and horizontally from the body (10) for the predetermined length (d1). The predetermined length (d1) of the first electrode (20) and the second electrode (30) is no less than the longitudinal length (d2) of the body (10). Therefore, the diode structure features two electrodes (20,30) with increased exposed surfaces and better heat dissipation.

## Description

### BACKGROUND OF THE INVENTION

Technical Field

The present invention relates to passive components, and more particularly, to a diode structure having better heat dissipation efficiency.

2. Description of Related Art

A diode is currently one of the basic constituent elements of a variety of electronic systems. A diode is characterized by its one-way current and thereby is capable of rectification; hence, electronic products are often equipped with diodes. According to the prior art, a diode comprises a cylindrical body and two electrodes extending outward from within the body. Afterward, to enable diodes to be applicable to a surface mount technology (SMT) process, the prior art teaches a rectangular body and two curved short thin electrodes coupled to the body such that they can be mounted on a printed circuit board.

A conventional diode has the following drawbacks: a bulky body, and two electrodes of a length that has to be short in order to meet the requirement of SMT-based assembly or circuit board jack assembly. However, when applying diodes to a solar cell junction box, diodes are easy to be flawed with poor heat dissipation due to high voltage operation and electrodes of a short length. Owing to their poor heat dissipation, diodes tend to be heated up after long use, and in consequence their electrodes develop a short circuit.

In view of this, it is important to carry out R&D and make improvement on diodes for use with solar cell junction boxes with a view to enhancing the heat dissipation efficiency of the diodes and reducing the chance that short circuits happen as a result of over-heating.

### SUMMARY OF THE INVENTION

In view of the aforesaid drawbacks of the prior art, it is an objective of the present invention to provide a improved diode structure. The diode structure comprises electrodes. Each of the electrodes is of a flat strip shape and has an exposed predetermined length. The exposed surface of the predetermined length of the electrode is thereby expanded and increased to function as the heat dissipation of the diode structure. Hence the heat dissipation efficiency of the diode structure is enhanced. It prevents short circuits from occurring to the diode structure due to poor heat dissipation.

Accordingly, the present invention provides a diode structure comprising a body, a first electrode, and a second electrode. The body has a longitudinal length, a transverse length, and a height. The longitudinal length is longer than the transverse length. The transverse length exceeds the height. The first electrode is of a flat strip shape, has an end extending into the body along the longitudinal length, and has another end extending outwardly and horizontally from the body for a predetermined length. The second electrode is of a flat strip shape, lies on another side of the body to oppose the first electrode, has a tail extending into the body, and has another tail extending outward and horizontally from the body for the predetermined length. The predetermined length of the first electrode and the second electrode is no less than the longitudinal length of the body.

### BRIEF DESCRIPTION OF THE SEVERAL VIEWS OF THE DRAWINGS

FIG. 1A is a perspective view of a diode structure according to the first embodiment of the present invention;

FIG. 1B is a cross-sectional view of the diode structure taken along line A-A of FIG. 1A according to the present invention;

FIG. 1C is a schematic top view of the diode structure of FIG. 1A according to the present invention; and

FIG. 2 is a perspective view of a diode structure according to the second embodiment of the present invention.

### DETAILED DESCRIPTION OF THE EMBODIMENTS OF THE INVENTION

The present invention relates to diode structures. The principle of diode is comprehensible to persons skilled in the art, and thus electronic theories of diode are not described in detail hereunder. The accompany drawings are illustrative of technical features of the diode structure of the present invention, but are not drawn to scale.

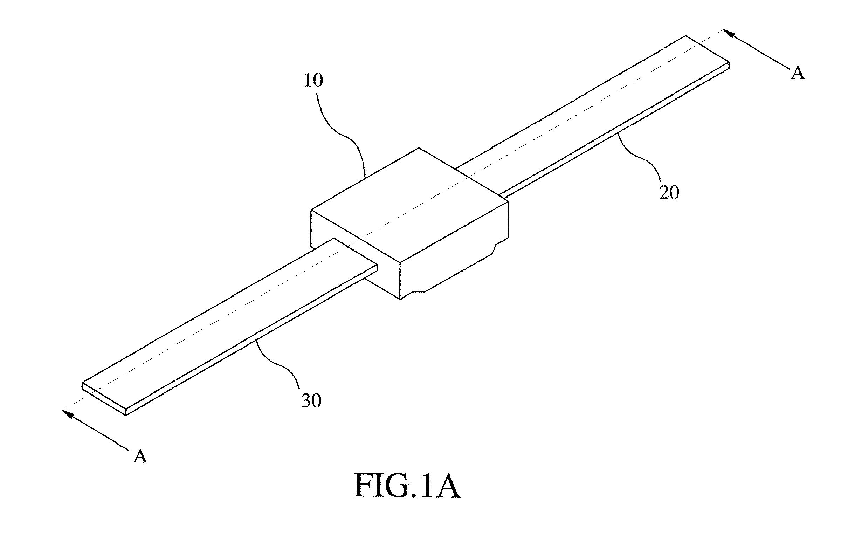

Referring to FIG. 1A, there is shown a perspective view of a diode structure according to the first preferred embodiment of the present invention. The diode structure shown in FIG. 1A comprises a body 10, a first electrode 20, and a second electrode 30. The first electrode 20 and the second electrode 30 serve as the positive pole and the negative pole of the diode structure, respectively, and locate in two sides of the body 10.

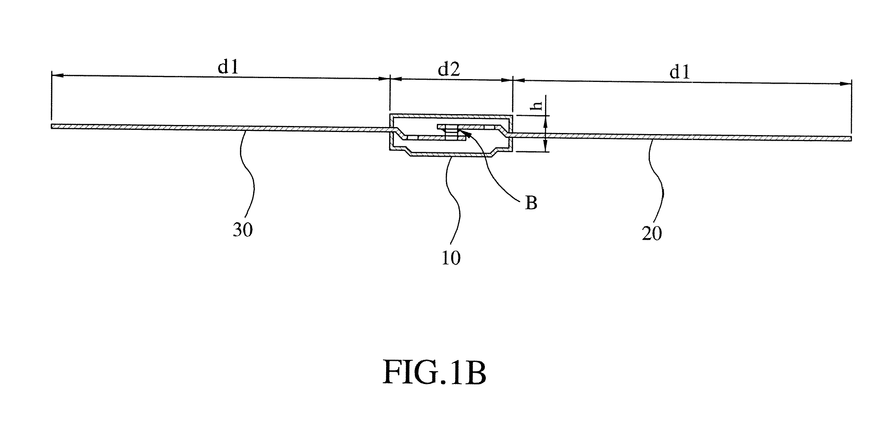

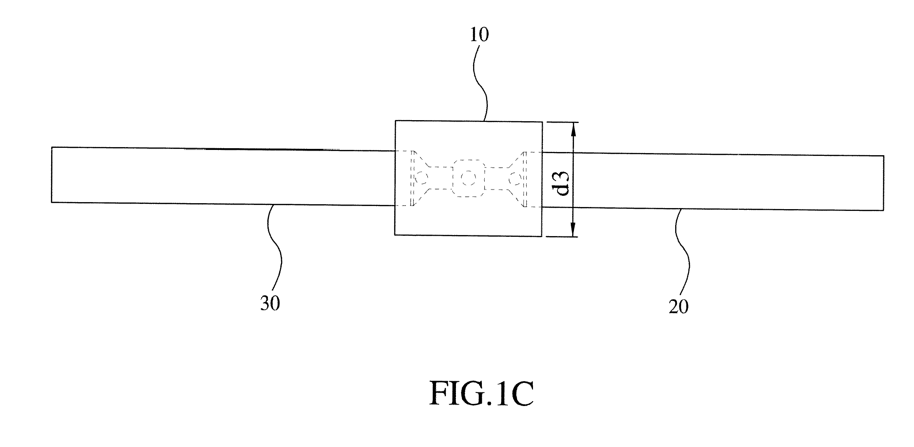

Referring to FIG. 1B and FIG. 1C, the body 10 in this embodiment is flat and rectangular, and has a longitudinal length d2, a transverse length d3, and a height h. The height h is shorter than the transverse length d3. Both the first electrode 20 and the second electrode 30 are of a flat strip shape. The first electrode 20 has an end that extends into the body 10 and has another end that extends outwardly and horizontally from the body 10 for a predetermined length d1. The second electrode 30 has a tail that extends into the body 10 and has another tail that extends outwardly and horizontally from the body 10 for the predetermined length d1.

The predetermined length d1 is no less than the longitudinal length d2 of the body 10. The end of the first electrode 20 and the tail of the second electrode 30 are positioned inside the body 10 and lie horizontally. The end of the first electrode 20 and the tail of the second electrode 30 further lie correspondingly each other in different positions, and are adapted to clamp a diode chip B which disposed inside the body 10. The end of the first electrode 20 and the tail of the second electrode 30 further electrically connect with the top side and the bottom side of the diode chip B, respectively.

Since the electrodes are made of metal, the exposed surface of the electrodes has a direct effect on heat dissipation efficiency. For the same volume, the flat electrode has more surface area than the cylindrical electrode has. To achieve optimal heat dissipation efficiency, it is feasible that the predetermined length d1 of the first electrode 20 and the second electrode 30 can be twofold longer than the longitudinal length d2 of the body 10. The outward extension length of the first electrode 20 and the second electrode 30 increases the exposed surface of the first electrode 20 and the second electrode 30, thereby enhances the heat dissipation efficiency of the diode structure. Hence, the heat which generated within the diode structure escapes therefrom quickly via the exposed surface to prevent the diode chip B from being burnt as a result of the high running heat of the diode structure, and in consequence there is no short circuit occurred between the first electrode 20 and the second electrode 30.

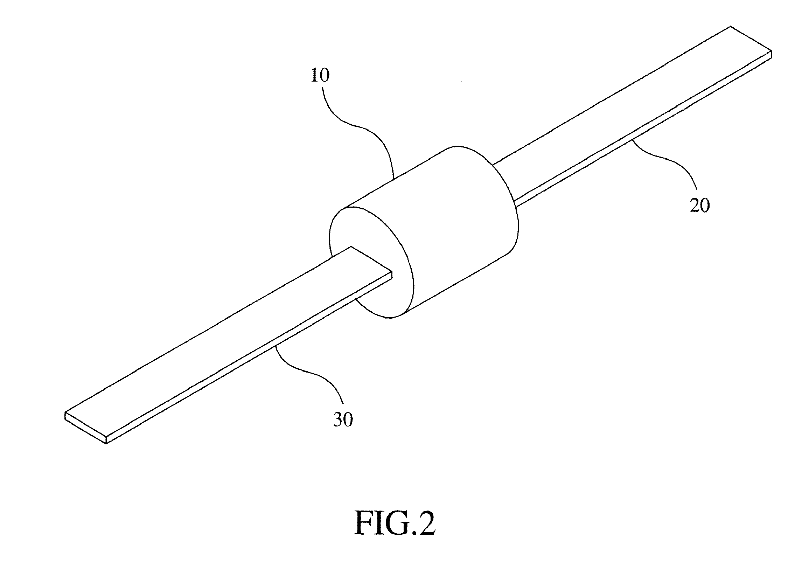

Referring to FIG. 2, there is shown a perspective view of a diode structure according to the second preferred embodiment of the present invention. In the second embodiment, the diode structure comprises a body 10', the first electrode 20, and the second electrode 30. The body 10' is cylindrical when comparing to the first embodiment. Besides, the way of connecting the body 10', the first electrode 20, and the second electrode 30 together in the second embodiment are the same as those in the first embodiment. Therefore is not reiterated hereunder for the sake of brevity.

In a variant embodiment of the present invention, it is feasible that the first electrode 20 and the second electrode 30 can extend outwardly and horizontally from the body 10 by different distances to adjust the heat dissipation efficiency of the diode structure. However, it is necessary that each of the predetermined length d1 of the first electrode 20 and the second electrode 30 is longer than the longitudinal length d2 of the body 10.

In the third preferred embodiment of the present invention, a stacked diode structure (not shown) is provided. The stacked diode structure is applicable to a high-voltage or high-current operation environment. Since the interior space of the solar cell junction box is small, enhancement of heat dissipation efficiency is required and satisfied by the stacked diode structure. The stacked diode structure comprises a plurality of diode structures. Each diode structure has a body identical to the body in the first preferred embodiment. The body of each diode structure is flat and rectangular. The diode structures are stacked up and adhered to each other along the height of the bodies. The first electrodes of all diode structures are electrically connected to each other, whereas the second electrodes of all diode structures are electrically connected to each other. Therefore, the stacked diode structure is effective in achieving uniform distribution of current and uniform heat dissipation, thereby enhancing the heat dissipation efficiency. Meanwhile, the stacked diode structure is provided only with a slight increase in volume,

Accordingly, the present invention provides a diode structure characterized by bilateral flat strip-shaped electrodes extending outward by a predetermined length to increase the exposed surface, to enhance the heat dissipation of the diode, and to prevent short circuits. The diode structure of the present invention comes in various forms to meet the requirement of different applications.

## Claims

1. A diode structure, comprising:
a body (10) having a longitudinal length (d2), a transverse length (d3), and a height (h), the longitudinal length (d2) being longer than the transverse length (d3), and the transverse length (d3) being not shorter than the height (h);
a first electrode (20) being of a flat strip shape, having an end extending into the body (10) along the longitudinal length (d2), and having another end extending outwardly and horizontally from the body (10) for a predetermined length (d1); and
a second electrode (30) being of a flat strip shape, lying on another side of the body (10) to oppose the first electrode (20), having a tail extending into the body (10), and having another tail extending outwardly and horizontally from the body (10) for the predetermined length (d1); **characterized in that**
wherein the predetermined length (d1) of the first electrode (20) and the second electrode is (30) no less than the longitudinal length (d2) of the body (10); wherein the end of the first electrode (20) and the tail of the second electrode (30) are lying horizontally inside the body (10), and lying correspondingly to each other in different vertical positions.

2. The diode structure of claim 1, wherein the body (10) is flat and rectangular.

3. The diode structure of claim 2, wherein a diode chip (B) is further provided and disposed inside the body (10), such that the end of the first electrode (20) and the tail of the second electrode (30) are disposed to clamp and electrically connect with a top side and a bottom side of the diode chip (B) respectively.

4. The diode structure of claim 2, wherein the predetermined length (d1) is twofold longer than the longitudinal length (d2) of the body (10).

5. The diode structure of claim 1, wherein the body (10) is cylindrical.

6. The diode structure of claim 5, wherein the transverse length (d3) is equal to the height (h).

7. The diode structure of claim 5, wherein the transverse length (d3) is longer than the height (h).

8. The diode structure of claim 5, wherein a diode chip (B) is further provided and disposed inside the body (10), such that the end of the first electrode (20) and the tail of the second electrode (30) are disposed to clamp and electrically connect with a top side and a bottom side of the diode chip (B) respectively.

9. The diode structure of claim 6, wherein the predetermined length (d1) is twofold longer than the longitudinal length (d2) of the body (10).

10. A stacked diode structure, comprising:
a plurality of diode structures each comprising:
a body (10) having a longitudinal length (d2), a transverse length (d3), and a height (h), the longitudinal length (d2) being longer than the transverse length (d3), and the transverse length (d3) being not shorter than the height(h);
a first electrode (20) being of a flat strip shape, having an end extending into the body (10) along the longitudinal length (d2), and having another end extending outwardly and horizontally from the body (10) for a predetermined length (d1); and
a second electrode (30) being of a flat strip shape, lying on another side of the body (10) to oppose the first electrode (20), having a tail extending into the body (10), and having another tail extending outwardly and horizontally from the body (10) for the predetermined length (d1); **characterized in that**
wherein the predetermined length (d1) of the first electrode (20) and the second electrode (30) is no less than the longitudinal length (d2) of the body (10); wherein the end of the first electrode (20) and the tail of the second electrode (30) are lying horizontally inside the body (10), and lying correspondingly to each other in different vertical positions; wherein the plurality of diode structures are stacked up and adhered to each other along the height (h) of the bodies (10), the first electrodes (20) of all diode structures are electrically connected to each other, and the second electrodes (30) of all diode structures are electrically connected to each other.

11. The stacked diode structure of claim 10, wherein a diode chip (B) is further provided and disposed inside the body (10) of each of the diode structures, such that the end of the first electrode (20) and the tail of the second electrode (30) are disposed to clamp and electrically connect with a top side and a bottom side of the diode chip (B) respectively.

12. The stacked diode structure of claim 10, wherein the predetermined length (d1) is twofold longer than the longitudinal length (d2) of the body (10).
